## Europäisches Patentamt
## European Patent Office
## Office européen des brevets

(19)

(11) Publication number: **0 041 643**
**B1**

(12)

# EUROPEAN PATENT SPECIFICATION

(45) Date of publication of patent specification: **17.09.86**

(51) Int. Cl.⁴: **G 03 C 1/68, G 03 F 7/16**

(21) Application number: **81104014.6**

(22) Date of filing: **25.05.81**

(54) **Self-trimming photosensitive layer.**

(30) Priority: **27.05.80 US 153635**

(43) Date of publication of application:
**16.12.81 Bulletin 81/50**

(45) Publication of the grant of the patent:
**17.09.86 Bulletin 86/38**

(84) Designated Contracting States:
**AT BE CH DE FR GB IT LI LU NL SE**

(56) References cited:
**FR-A-2 228 797**
**GB-A-1 150 829**
**US-A-2 760 863**
**US-A-4 075 051**

(73) Proprietor: **E.I. DU PONT DE NEMOURS AND COMPANY**
**1007 Market Street**
**Wilmington Delaware 19898 (US)**

(72) Inventor: **Pilette, Yvan Philip**
**7 Meadow Run Road**
**Lawrenceville New Jersey 08648 (US)**
Inventor: **Beske, Grant Allen**
**4 Berkshire Drive**
**Princeton New Jersey 08550 (US)**

(74) Representative: **Werner, Hans-Karsten, Dr. et al**
**Deichmannhaus am Hauptbahnhof**
**D-5000 Köln 1 (DE)**

Courier Press, Leamington Spa, England.

# 0 041 643

**Description**

Technical field
The invention relates to a photo resist element upon a strippable support which is self-trimming when it is laminated to a substrate.

U.S. Patent 4,075,051 discloses a process for self-trimming of a photoresist layer laminated to a substrate, i.e., the portion of the layer extending past the edges of the substrate is removed without any cutting step. This is accomplished by applying a liquid weakening agent at least to the aforesaid portion of the layer, but possibly to the entire layer by pre-wetting of the substrate with the agent, and then peeling away a support film or auxiliary permeable sheet which has a greater adhesion to the layer than the cohesive strength (as a result of the weakening agent) of the layer. The accuracy of this self-trimming, i.e., the coincidence of the trimmed layer with the edges of the substrate and the smoothness of the trimmed edges of the layer depends on the weakening effect of the particular liquid agent used and its amount. When the liquid agent has only minimal effect on the layer and is used in only a small amount, the ability to do accurate self-trimming suffers accordingly. Furthermore, liquid agents which weaken the resist are also likely to weaken other functional properties of the photosensitive layer, e.g., tenting strength and resistance to plating conditions.

FR—A—2,228,797 describes a photopolymerizable paste which contains inorganic particulate material in an amount up to 85% by weight of the composition. The inorganic material allows a film applied by screen printable techniques to be fired to decompose or burn the organic portion of the composition.

The purpose of this invention is to prepare a composition which is self-trimmable by application of tensile stress. This composition is nonfirable in the manner of the prior art teachings.

This invention, therefore is directed to a photoresist element comprising a photosensitive layer coated upon a strippable support, the photosensitive layer when laminated to a substrate being self-trimmable on the edges of the substrate by the application of the tensile stress to the layer transversely to the edge, when the strippable support is removed, comprising (a) an addition polymerizable ethylenically unsaturated monomer, (b) an initiating system activatable by actinic radiation and (c) a binder comprising a continuous major phase of organic polymer compatible with (a) and (b) and a discontinuous minor phase of randomly dispersed nonfibrous solid particles having a particle size of from 0.1 to 25 µm, the optical density (Enzyklopädie Naturwissenschaft und Technik, Vol. 3, 1980, page 3103, "Optische Dicke τ") of the layer being below 0.7 and the photopolymerizable composition being present in dry coating thickness of 0.0008 to 0.025 cm, characterized in that said solid particles are polyolefine or poly-(tetrafluoroethylene), the photosensitive layer has an elongation at break between 2 and 50%, and the photosensitive layer without the solid particles has an elongation at break of greater than 150%.

Finally this invention is directed to a method of trimming a polymeric material evenly along the edge of a substrate having the polymeric layer laminated thereto by applying a tensile stress transversely to the edge of the laminated layer in excess of the tensile breaking strength of the layer, characterized in that a discontinuous minor phase of randomly dispersed nonfibrous solid particles having a particle size of from 0.1 to 25 µm is incorporated into the polymeric layer which has an elongation at break of greater than 150% without the solid particles and an elongation at break between 2 and 50% with the solid particles.

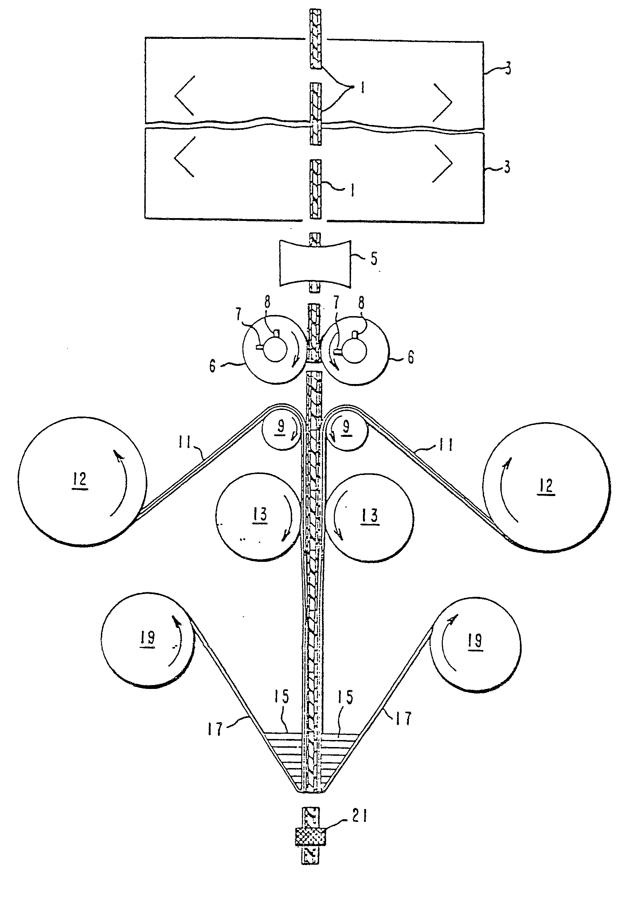

The advantages of the invention and the details of the manner in which it can be used will be apparent by reference to the drawing which consists of a single figure illustrating schematically a preferred way of utilizing the invention in a continuous process.

The above-described invention involves the discovery that the incorporation of a discontinuous phase of certain kinds of solid particles in a continuous phase of binder results in a photosensitive composition which, when formed as a thin layer, is easily trimmed at the edge of a substrate merely by the application of a tensile stress to the layer transversely to the edge of the substrate.

A wide variety of particulate materials may be used in the invention such as polyolefins as polyethylene, polypropylene and polytetrafluoroethylene.

However, though the compositional variety of such materials is quite extensive they must nevertheless possess certain properties to be useful in the photosensitive layers of the invention.

Firstly, the size of the particulate materials must not be greater than the thickness of the film in which they are used and preferably should be less in order that they do not interfere with adhesion of the layer to the substrate. The size of the particles is from 0.1 to 25 µm and not more than about 15 µm when they are used in 0,025 µm (1 mil) layers. Secondly, the particles must be nonfibrous in character so that they do not reinforce or strengthen the binder. Thirdly, the particles must be almost completely insoluble in the other components of the photosensitive layer (monomer, binder and initiator) so that they in fact form a discontinuous dispersion. Finally, the particles must be inert with respect to the other components of the photosensitive layer.

Beyond the above-described primary characteristics of the particles when they are formulated the resultant photosensitive layer must possess an elongation at break between 2 and 50% and preferably between 5 and 30%. As used herein the term elongation at break refers to the percent of elongation when the layer is broken by the application of a tensile stress of 2.54 cm (1 inch) per minute using an Instron® Model TPB Tester. An elongation at break below 2% is to be avoided because the layer may lack sufficient

2

flexibility. It is preferred not to use solids which are opaque or highly colored in order to avoid interference with image resolution by light scattering and with photospeed by absorbing light.

The particle size, shape and uniformity affect the suitability of use of any particular material in the invention. For example, some materials in concentrations which are capable of yielding suitable elongation at break may result in too high an optical density and thus they are unsuitable for use in that particular binder system. A particular material may meet all of the four particle criteria listed above and yet be unsuitable in a given photosensitive layer system. On the other hand, a change of binder may render the same particulate material suitable. Thus, even though the particulate materials may not be characterized in any single generic manner they are readily ascertained by simple experimentation.

Because the above-described particles are being used in photosensitive layers it is preferred that they be fairly uniform as to size distribution so that image resolution of the layer is maximized. For the same reason it is preferred that the particles be at least translucent and still more preferably transparent in order that appropriate image resolution can be achieved at higher particulate concentrations. Notwithstanding such translucency and uniformity size, it is preferred that the photosensitive layer contain less than 30% by weight beads in order that image resolution will not be reduced excessively by light scattering and that undercutting of the image be minimized. It is also necessary for many applications of the invention that the optical density of the formulated layer be below about 0.7, measured at a wavelength of 350 to 400 nm.

Especially preferred particulates are polyolefins as polyethylene and polypropylene beads and poly(tetrafluoroethylene) powder.

In practicing the invention, photosensitive film resist elements of various types may be used. In general photohardenable, negative-working elements are photopolymerizable elements of the type disclosed in U.S. Patent 3,469,982 and the photocrosslinkable elements of the type disclosed in U.S. Patent 3,526,504. Positive-working, resist elements may be of the photosolubilizable type, e.g., such as the o-quinone diazide elements of U.S. Patent 3,837,860, or of the photodesensitizable type, e.g., such as the bisdiazonium salts of U.S. Patent 3,778,270 or the nitroaromatic compositions of U.K. Patent 1,547,548.

An element containing an image-yielding photopolymerizable stratum on a strippable support is preferably used. The remaining surface of the supported, photopolymerizable stratum may be protected by a removable cover sheet or when the element is stored in roll form, the stratum surface may be protected by the contiguous reverse surface of the support. The photopolymerizable composition is present in a dry coating thickness of about 0.0008 cm (0.0003 inch) to about 0.025 cm (0.01 inch) or more. A suitable strippable support which preferably has a high degree of dimensional stability to temperature changes, may be chosen from a wide variety of films composed of high polymers, e.g., polyamides, polyolefins, polyesters, vinyl polymers, and cellulose esters, and may have a thickness of from 0.0006 cm (0.00025 inch) to 0.02 cm (0.008 inch) or more. If exposure is to be made before removing the strippable support, it must, of course, transmit a substantial fraction of the actinic radiation incident upon it. If the strippable support is removed prior to exposure, no such restrictions apply. A particularly suitable support is a transparent polyethylene terephthalate film having a thickness of about 0.0025 cm (0.001 inch).

When the element contains no removable, protective cover sheet and is to be stored in roll form, the reverse side of the strippable support preferably has applied thereto a thin release layer of a material, such as wax or silicone, to prevent blocking with the photopolymerizable stratum. Alternatively, adhesion to the coated photopolymerizable layer may be preferentially increased by flame treating or electrical discharge treating the support surface to be coated.

Suitable removable, protective cover sheets when used may be chosen from the same group of high polymer films described above and may have the same wide range of thicknesses. A cover sheet of 0.0025 cm (0.001 inch) thick polyethylene is especially suitable. Supports and cover sheets as described above provide good protection to the photopolymerizable resist layer.

The photohardenable layer is prepared from polymeric components (binders), monomeric components, initiators and inhibitors.

Suitable binders which can be used as the sole binder or in combination with others include the following: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers; polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides, e.g., N-methoxymethyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose; polycarbonates; polyvinyl acetal, e.g., polyvinyl butyral, polyvinyl formal; polyformaldehydes.

Preferably, the binder should contain sufficient acidic or other groups to render the composition processible in aqueous developer. Useful aqueous-processible binders include those disclosed in U.S. Patent 3,458,311 and in U.K. Patent 1,507,704. Useful amphoteric polymers include interpolymers derived from N-alkylacrylamides or methacrylamides, acidic film-forming comonomer and an alkyl or hydroxyalkyl acrylate such as those disclosed in U.S. Patent 3,927,199.

Suitable monomers which can be used as the sole monomer or in combination with others include the following: t-butyl acrylate, 1,5 - pentanediol diacrylate, N,N - diethylaminoethyl acrylate, ethylene glycol diacrylate, 1,4 - butanediol diacrylate, diethylene glycol diacrylate, hexamethylene glycol diacrylate, 1,3 - propanediol diacrylate, decamethylene glycol diacrylate, decamethylene glycol dimethacrylate, 1,4 - cyclohexanediol diacrylate, 2,2 - dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylated and trimethacrylate and similar compounds as disclosed in U.S. Patent 3,380,831, 2,2 - di(p - hydroxyphenyl) - propane diacrylate, pentaerythritol tetraacrylate, 2,2 - di - (p - hydroxyphenyl) - propane dimethacrylate, triethylene glycol diacrylate, polyoxyethyl - 2,2 - di - (p - hydroxyphenyl) - propane dimethacrylate, di - (3 - methacryloxy - 2 - hydroxypropyl) ether of bisphenol-A, di - (2 - methacryloxyethyl) ether of bisphenol-A, di - (3 - acryloxy - 2 - hydroxypropyl) ether of bisphenol-A, di - (2 - acryloxyethyl) ether of bisphenol-A, di - (3 - methacryloxy - 2 - hydroxypropyl) ether of tetrachloro - bisphenol-A, di - (2 - methacryloxyethyl) ether of tetrachloro - bisphenol-A, di - (3 - methacryloxy - 2 - hydroxypropyl) ether of tetrabromo - bisphenol-A, di - (2 - methacryloxyethyl) ether of tetrabromo - bisphenol-A, di - (3 - methacryloxy - 2 - hydroxypropyl) ether of 1,4 - butanediol, di - (3 - methacryloxy - 2 - hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3 - propanediol dimethacrylate, 1,2,4 - butanetriol trimethacrylate, 2,2,4 - trimethyl - 1,3 - pentanediol dimethacrylate, pentaerythritol trimethacrylate, 1 - phenyl ethylene - 1,2 - dimethacrylate, pentaerythritol tetramethacrylate, trimethylol propane trimethacrylate, 1,5 - pentanediol dimethacrylate, diallyl fumarate, styrene, 1,4 - benzenediol dimethacrylate, 1,4 - diisopropenyl benzene, and 1,3,5 - triisopropenyl benzene.

In addition to the ethylenically unsaturated monomers mentioned above, the photohardenable layer can also contain at least one of the following free radical-initiated, chain-propagating, addition-polymerizable, ethylenically unsaturated compounds having a molecular weight of at least 300. Preferred monomers of this type are an alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such materials wherein the ethylenically unsaturated groups, especially the vinylidene groups, are conjugated with ester or amide structures.

Preferred free radical-generating addition polymerization initiators activatable by actinic light and thermally inactive at and below 185°C include the substituted or unsubstituted polynuclear quinones which are compounds having two intracyclic carbon atoms in a conjugated carbocyclic ring system, e.g., 9,10 - anthraquinone, 1 - chloroanthraquinone, 2 - chloroanthraquinone, 2 - methylanthraquinone, 2 - ethylanthraquinone, 2 - tert - butylanthraquinone, octamethylanthraquinone, 1,4 - naphthoquinone, 9,10 - phenanthrenequinone, 1,2 - benzanthraquinone, 2,3 - benzanthraquinone, 2 - methyl - 1,4 - naphthoquinone, 2,3 - dichloronaphthoquinone, 1,4 - dimethylanthraquinone, 2,3 - dimethylanthraquinone, 2 - phenylanthraquinone, 2,3 - diphenylanthraquinone, sodium salt of anthraquinone alpha-sulfonic acid, 3 - chloro - 2 - methylanthraquinone, retenequinone, 7,8,9,10 - tetrahydronaphthacenequinone, and 1,2,3,4 - tetrahydrobenz(a)anthracene - 7,12 - dione.

Other photoinitiators which are also useful, even though some may be thermally active at temperatures as low as 85°C, are described in U.S. Patent 2,760,863 and include vicinal ketaldonyl alcohols, such as benzoin, pivaloin, acyloin ethers, e.g., benzoin methyl and ethyl ethers; α-hydrocarbon-substituted aromatic acyloins, including α-methylbenzoin, α-allylbenzoin and α-phenylbenzoin. Photoreducible dyes and reducing agents disclosed in U.S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenyl-imidazolyl dimers with hydrogen donors, and mixtures thereof as described in U.S. Patents: 3,427,161; 3,479,185; and 3,549,367 can be used as initiators. Also useful with photoinitiators and photoinhibitors are sensitizers disclosed in U.S. Patent 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6 - di - tert - butyl - p - cresol, phenothiazine, pyridine, nitrobenzene and dinitrobenzene, p-toluquinone and chloranil.

4

Also useful for thermal polymerization inhibition are the nitroso compositions disclosed in U.S. Patent 4,168,982.

Various dyes and pigments may be added to increase the visibility of the resist image. Any colorant used, however, should preferably be transparent to the actinic radiation used.

Generally, suitable substrates for the process of the invention involving printed circuit formation are those which have mechanical strength, chemical resistance and good dielectric properties. Thus, most board materials for printed circuits are thermosetting or thermoplastic resins usually combined with a reinforcing agent. Thermosetting resins with reinforcing fillers are ordinarily used for rigid boards, whereas thermoplastic resin without reinforcements are usually used for flexible circuit boards. The materials from which the board is made may, of course, influence the choice of liquid for the thin layer.

Typical board construction involves combinations such as phenolic or epoxy resins on paper or a paper-glass composite, as well as polyester, epoxy, polyimide, polytetrafluorethylene, or polystyrene on glass. In most instances, the board is clad with a thin layer of electroconductive metal of which copper is by far the most common.

Suitable substrates for the process of the invention involving preparation of lithographic printing plates are those which have mechanical strength and surfaces which differ in hydrophilicity or oleophilicity from the surfaces of the imaged photosensitive areas laminated thereto. Such substrates are disclosed in U.S. Patent 4,072,528. While numerous substrates are satisfactory for this purpose thin anodized aluminum plates such as those disclosed in U.S. Patent 3,458,311 are particularly useful.

It will be recognized by those skilled in the art that it will be preferable for the printed circuit substrate surface which is to be laminated to be clean and free of any extraneous material which might render any significant amount of the surface nonwettable. For this reason, it will frequently be desired to clean printed circuit substrates prior to lamination by one or more of the several cleaning processes which are well-known in the field of printed circuit board manufacture. The particular type of cleaning depends upon the type of contamination—organic, particulate or metallic. Such methods include degreasing with solvents and solvent emulsions, mechanical scrubbing, alkaline soaks, acidification and the like, followed by rinsing and drying.

The invention will be more clearly understood by reference to the following examples and the detailed description of the Drawing hereinbelow.

Example I—Resist properties

A roll of photoresist film having no cover sheet is prepared as follows:

A photosensitive coating solution is prepared having the following composition:

| | | Component | g |
|---|---|---|---|
| (a) | | 1:1 Copolymer of styrene and maleic anhydride partially esterified with isobutyl alcohol; mol. wt. ca. 20,000; acid number ca. 180 | 40 |
| (b) | | Terpolymer of 17% ethyl acrylate, 71% methyl methacrylate, and 12% acrylic acid; mol. wt. ca. 300,000; acid number ca. 105 | 12.6 |
| (c) | | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 5 |
| (d) | | Polyoxyethylated trimethylolpropane triacrylate (20 moles of ethylene oxide) (M.W. 1162) | 10 |
| (e) | | Trimethylolpropane triacrylate | 12.5 |
| (f) | | Benzophenone | 4 |
| (g) | | 4,4'-Bis(dimethylamino) benzophenone (Michler's ketone) | 0.7 |
| (h) | | 2,2'-Bis(2-chlorophenyl)-4,4',5,5'-tetraphenyl biimidazole | 3 |
| (i) | | Leuco crystal violet | 0.4 |
| (j) | | Benzotriazole | 0.2 |
| (k) | | 1,4,4-Trimethyl-2,3-diazobicyclo-[3.2.2]-non-2-ene-2,3-dioxide | 0.06 |
| (l) | | Victoria Green (C.I. Pigment Green 18) | 0.03 |
| (m) | | Methylene chloride | 200 |
| (n) | | Methanol | 15 |

Into the above coating solution are dispersed 13 parts by weight of polyethylene beads of which 85% have diameters below 10 μm and 15% have diameters between 10 and 20 μm. The mixture is coated on a 0.00127 cm thick poly(ethylene terephthalate) web which has coated on its reverse side a thin layer of a mixture of Carnuba wax and poly(vinylidene chloride). The photopolymerizable layer is dried to give a dry thickness of 0.00254 cm and about 30.5 m of the dried coated element is wound into a roll.

Detailed description of the drawing

Turning now to the drawing, each member of a series of substrates for printed circuits 1 is mechanically advanced in a continuous manner on a roller conveyor through cleaning chamber 3 in which both the upper and lower copper-clad surfaces thereof are cleaned by mechanically scrubbing under a heavy water spray. The substrates are made of fiberglass-reinforced epoxy resin. The cleaned substrates are further advanced through alignment rolls 5 by which the sides of the boards are precisely aligned. From the alignment rolls 5, each aligned board emerges and is passed between liquid application rolls 6 into which thin layer liquid (in this case, 30% ethanol/water solution) is admitted via line 7 into the interior of the hollow application rolls 6. Preferably the application rolls 6 consists of a metal core perforated in a regular pattern having thereon a hard porous polyethylene sleave which is covered with a cotton cloth through which the thin layer liquid passes and is coated onto the substrate. Liquid level within the application rolls 6 is limited by fixed level outlet line 8. The liquid films have a thickness of 10 to 50 μm. The board with both surfaces coated with a thin layer of liquid is then advanced to a set of upper and lower feed rolls 9 each of which places the unprotected surface of the photosensitive layer of the continuous resist film 11 against the thin liquid layer.

The feed rolls 9 place the photosensitive layer against the surface of the substrate without any significant pressure just before the layer and substrate pass to the nip of the laminating rolls. Any excess liquid is removed from the substrate surface by forming a bead at the nip as the element passes between feed rolls 9. By this means moisture is retained between the layer and substrate and thermal exposure of the layer is limited to the brief time it is within the nip. In the event of a stoppage, the amount of film subject to thermal degradation is reduced substantially.

The feed rolls 9 are mechanically linked with the mechanism used for advancing the boards 1 in such manner that the boards are butted up against one another as they enter the feed rolls 9 and there is no significant amount of bridging by the film 11 between the trailing and leading edges of each board. The laminating film prepared as described in Example I is supplied from supply roll 12. The abutting boards 1 with the film resist 11 in place is then advanced through the nips of heated laminating rolls 13 in which the film layers 11 are subjected to both pressure and heat, by which the thin water layer on the photosensitive layer is removed from the substrate mainly by absorption onto the photosensitive layer. The temperature of the laminating roll surfaces is about 109,9°C (230°F) and the linear speed of the boards through the laminator is about 1,83 m (six feet) per minute. During the laminating steps minor amounts of liquid are removed by evaporation. The laminated boards 1 still abutting each other, are advanced at a uniform rate between wedges 15. At the exit of the wedges 15, the polyethylene terephthalate web 17 on the outer surface of the continuous film is pulled back uniformly from the substrate at an obtuse angle (here 150°) which causes the photosensitive layer to be trimmed in a straight line along the leading edge of the board 1). The web 17 is pulled back by the action of take-up rolls 19 and the advancing action of the board. As the substrate board 1 emerges from between wedges 15 progressively more of the photosensitive layer is uncovered until the board advances to and is grasped firmly at the sides between a pair of clutch-driven rapidly rotating trimming rolls 21 (only one is shown) which rotate at a speed faster than the linear speed of the advancing board until they grasp the panel sides. The trimming rolls then move with the linear speed of the board by means of a slip clutch which compensates for the difference in driving speeds. The trimming rolls 21 place a transverse tensile stress on the board which causes the photosensitive layer to be trimmed smoothly along the trailing edge of the board as it emerges from between the wedges 15. When the trailing edge trimming is completed, thus separating the leading and trailing boards in the series, the laminated board is ready for circuit preparation by conventional photoresist techniques.

Though the process of the invention as described above is carried out continuously, it will be recognized that the process can also be conducted intermittently as well.

Though the invention may be used advantageously in a broad spectrum of photosensitive applications it is particularly useful for the preparation of photoresist elements for lamination to substrates to be used in making printed circuit boards and lithographic printing plates.

The exact mechanism by which the photosensitive layers of the invention are rendered self-trimming is not known with certainty. However, it appears that the particles make the photosensitive layer less elongatable and provide a path for smooth, accurate breaking of the film when it is subject to a transverse tensile stress. To obtain smooth trimming of the photosensitive layer along the substrate edge it is necessary to apply the tensile force transversely to the edge along which the layer is to be torn. Preferably the tensile force should be applied in a perpendicular manner.

It is of course recognized that particles similar to those used in the invention have been incorporated in photosensitive compositions as fillers or extenders and for other purposes as well. For example, dispersed transparent filler particles in photopolymerizable compositions are disclosed in U.S. Patent 3,261,686 to provide improved strength of the layer, reduced tack, and for coloring the composition. Fillers have been used for compositions used for making printing relief from a layer thickness of at least 0,076 mm (3 mils) because the nature of the printing relief requires high strength and reduced tack. Tack reduction in particular did not affect adhesion of the printing relief to a rigid support because an adhesive interlayer was used to adhere the layer and the printing relief obtained therefrom to the rigid support.

**0 041 643**

Example II

A photoresist element was prepared from the following photosensitive coating solution:

| | | Component | g |
|---|---|---|---|
| (a) | | 1:1 Copolymer of styrene and maleic anhydride partially esterified with isobutyl alcohol; mol. wt. ca. 20,000; acid number ca. 180 | 46.8 |
| (b) | | Terpolymer of 17% ethyl acrylate, 71% methyl methacrylate, and 12% acrylic acid; mol. wt. ca. 300,000; acid number ca. 105 | 15.0 |
| (c) | | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 5.0 |
| (d) | | Polyoxyethylated trimethylolpropane triacrylate (20 moles of ethylene oxide) (M.W. 1162) | 12.0 |
| (e) | | Trimethylolpropane triacrylate | 15.0 |
| (f) | | Benzophenone | 3.0 |
| (g) | | Michler's ketone | 0.25 |
| (h) | | 2,2'-Bis(2-chlorophenyl)-4,4',5,5'-tetraphenyl biimidazole | 3.0 |
| (i) | | Leuco crystal violet | 0.4 |
| (j) | | 1,4,4-Trimethyl-2,3-diazobicyclo-[3.2.2]-non-2-ene-2,3-dioxide | 0.03 |
| (k) | | Victoria Green (C.I. Pigment Green 18) | 0.03 |
| (l) | | Methylene chloride | 200 |
| (m) | Methanol | | 17 |

Into the above coating solution were dispersed 15 g of snow-white polyolefin beads of which about 85% by weight were 10 µm or smaller and about 15% were between 10 and 20 µm in size (Verbafine A-616, tradename of Dura Commodities Corporation, Harrison, NY). The mixture was coated on a 0.00127 cm thick poly(ethylene terephthalate) web to form a dry coating of 0.00254 cm. The layer was laminated to a copper-clad circuit board substrate using the method described in EP—A—0040842 using 30% by weight ethanol in water for treatment of the substrate prior to lamination. The resultant laminated substrate was imaged by exposure through appropriate artwork for 30 seconds to the visible light of a Colight® DMVL-HP light source and developed in an aqueous solution of 1% by weight sodium carbonate at 29,41°C (85°F). The photoresist image was then used as a tin-lead electroplating resist with excellent results. The photosensitive layer had an elongation at break of about 45% and optical density below 0.7.

8

Example III

Another photoresist element was prepared from the following photosensitive coating solution.

| | | Component | g |
|---|---|---|---|
| (a) | | 1:1 Copolymer of styrene and maleic anhydride partially esterified with isobutyl alcohol; mol. wt. ca. 20,000; acid number ca. 180 | 46.8 |
| (b) | | Terpolymer of 17% ethyl acrylate 71% methyl methacrylate, and 12% acrylic acid; mol. wt. ca. 300,000; acid number ca. 105 | 15.0 |
| (c) | | Interpolymer formed from 40% N-tert.-octyl acrylamide, 34% methyl methacrylate, 16% acrylic acid, 6% hydroxy propyl methacrylate, and 4% t-butylamino ethyl methacrylate; mol. wt. ca. 50,000 | 5.0 |
| (d) | | Polyoxyethylated trimethylolpropane triacrylate (20 moles of ethylene oxide) (M.W. 1162) | 12.0 |
| (e) | | Trimethylolpropane triacrylate | 15.0 |
| (f) | | Benzophenone | 3.0 |
| (g) | | Michler's ketone | 0.25 |
| (h) | | 2,2'-Bis(2-chlorophenyl)-4,4',5,5'-tetraphenyl biimidazole | 3.0 |
| (i) | | Leuco crystal violet | 0.4 |
| (j) | | 1,4,4-Trimethyl-2,3-diazobicyclo-[3.2.2]-non-2-ene-2,3-dioxide | 0.03 |
| (k) | | Victoria Green (C.I. Pigment Green 18) | 0.03 |
| (l) | | Methylene chloride | 200 |
| (m) | | Methanol | 17 |

Into the above coating solution were dispersed 15 g of poly(tetrafluoroethylene) particles having an average size of about 2.6 μm (Teflon® 7A, tradename of E.I. du Pont de Nemours and Company, Wilmington, DE). The mixture was coated, laminated, exposed and developed in the same manner as Example II and used as a tin/lead electroplating resist with similar excellent results. The photosensitive layer had an elongation at break of about 45% and optical density of below 0.7.

9

Example IV
A further photoresist element was prepared from the following photosensitive coating solution:

| | | Component | g |
|---|---|---|---|
| (a) | | Terpolymer of 17% ethyl acrylate, 71% methyl methacrylate, and 12% acrylic acid; mol. wt. ca. 300,000; acid number ca. 105 | 3.5 |
| (b) | | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 22.0 |
| (c) | | Trimethylolpropane triacrylate | 15.0 |
| (d) | | Benzophenone | 2.0 |
| (e) | | Michler's ketone | 0.25 |
| (f) | | 2,2'-Bis(2-chlorophenyl)-4,4',5,5'-tetraphenyl biimidazole | 0.5 |
| (g) | | Leuco crystal violet | 0.05 |
| (h) | | Benzotriazole | 0.1 |
| (i) | | 1,4,4-Trimethyl-2,3-diazobicyclo-[3.2.2]-non-2-ene-2,3-dioxide | 0.03 |
| (j) | | Victoria Green (C.I. Pigment Green 18) | 0.03 |
| (k) | | Methylene chloride | 100 |
| (l) | | Methanol | 8.5 |

Into the above coating solution were dispersed 10 g of talcum powder having an average particle size of about 20 μm. The mixture was processed and used in the same manner as Example I with similarly favorable results. The photosensitive layer had an elongation at break of about 30% and optical density below 0.7.

This example supports the method claim only.

10

Example V

Another photoresist element was prepared from the following photosensitive coating solution:

| | | Component | g |
|---|---|---|---|
| (a) | | Terpolymer of 17% ethyl acrylate, 71% methyl methacrylate, and 12% acrylic acid; mol. wt. ca. 300,000; acid number ca. 105 | 3.5 |
| (b) | | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 22.0 |
| (c) | | Trimethylolpropane triacrylate | 15.0 |
| (d) | | Benzophenone | 2.0 |
| (e) | | Michler's ketone | 0.25 |
| (f) | | 2,2'-Bis(2-chlorophenyl)-4,4',5,5'-tetraphenyl biimidazole | 0.5 |
| (g) | | Leuco crystal violet | 0.05 |
| (h) | | Benzotriazole | 0.1 |
| (i) | | 1,4,4-Trimethyl-2,3-diazobicyclo-[3.2.2]-non-2-ene-2,3-dioxide | 0.03 |
| (j) | | Victoria Green (C.I. Pigment Green 18) | 0.03 |
| (k) | | Methylene chloride | 100 |
| (l) | | Methanol | 8.5 |

Into the above coating solution were dispersed 20 g of 1 μm polyethylene beads (Microfine VIII-F Gold tradename of Dura Commodities Corporation, Harrison, NY). The mixture was processed and used in the same manner as Example I with like results. The photosensitive layer had an elongation at break of about 60% and optical density below 0.7.

11

Example VI

A roll of photoresist film having no cover sheet is prepared from the following coating solution:

| | | Component | g |
|---|---|---|---|
| (a) | | 1:1 Copolymer of styrene and maleic anhydride partially esterified with isobutyl alcohol; mol. wt. ca 20,000; acid number ca. 180 | 40 |
| (b) | | Terpolymer of 17% ethyl acrylate, 71% methyl methacrylate, and 12% acrylic acid; mol. wt. ca. 300,000; acid number ca. 105 | 12.6 |
| (c) | | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 5 |
| (d) | | Polyoxyethylated trimethylolpropane triacrylate (20 moles of ethylene oxide) (M.W. 1162) | 10 |
| (e) | | Trimethylolpropane triacrylate | 12.5 |
| (f) | | Benzophenone | 4 |
| (g) | | Michler's ketone | 0.7 |
| (h) | | 2,2'-Bis(2-chlorophenyl)-4,4',5,5'-tetraphenyl biimidazole | 3 |
| (i) | | Leuco crystal violet | 0.4 |
| (j) | | Benzotriazole | 0.2 |
| (k) | | 1,4,4-Trimethyl-2,3-diazobicyclo-[3.2.2]-non-2-ene-2,3-dioxide | 0.06 |
| (l) | | Victoria Green (C.I. Pigment Green 18) | 0.03 |
| (m) | | Methylene chloride | 200 |
| (n) | | Methanol | 15 |

Into the above coating solution was mixed 13 grams of synthetic amorphous silica particles having an average particle size of 7 microns. (Syloid 309 Silica, tradename of Davison Chemical Div. of W. R. Grace and Co., New York, NY). The mixture was processed and used in the same manner as Example I with essentially the same good results. The photoresist layer had an elongation at break of about 40% and optical density below 0.7.

This example supports the method claim only.

Example VII—Positive photoresist lamination

| | Component | g |
|---|---|---|
| (a) | Methyl methacrylate/methacrylic acid (92/8) copolymer medium molecular weight | 54.4 |
| (b) | Trimethylolpropane triacrylate | 36 |
| (c) | 2,2'-Bis(2-chlorophenyl)-4,4',5,5'-tetraphenyl biimidazole | 3 |
| (d) | Triethyleneglycol diacetate | 1 |
| (e) | Tricresyl phosphate | 3 |
| (f) | 3-[N-ethyl-2,3,4-trihydro-1H-benzo[b]-pyridin-6-yl]methylidyne-2,3-dihydro-4-H-1-benzopyran-4-one | 1 |
| (g) | 4,5-Dimethoxy-2-nitro-1[-1[4(1,1-dimethyl ethyl)phenoxy]ethyl]-benzene | 4 |
| (h) | Benzotriazole | 0.2 |
| (i) | CI-109 Red Dye | 0.3 |
| (j) | Methylene chloride | 150 |
| (k) | Methanol | 11 |
| (l) | Polyethylene beads of Example I | 15 |

The mixture is coated on a 0.00127 cm thick polyethylene terephthalate web and dried to give a photosensitive layer with a dry thickness of 0.00254 cm. The layer had an elongation at break of about 45% and optical density below 0.7.

The photosensitive layer is laminated to one side of cleaned copper-clad substrate boards and self trimmed as in Example II.

Each of the laminated and trimmed boards is imaged by exposing for sixty seconds the photosensitive layer to UV radiation from a Colight® DMVL-HP light source passing through transparent portions of a phototool corresponding to a printed circuit pattern. The phototool is then removed and replaced with a filter which is opaque to UV radiation below 400 nm and the boards are uniformly exposed for 60 seconds to the visible light of the Colight® DMVL-HP light source. The imagewise exposed areas are completely removed by development in an aqueous solution of 9% ethyleneglycol monobutyl ether and 1% sodium borate. The imaged and developed laminate is ready for circuit preparation by conventional plating and etching photoresist techniques.

## 0 041 643

Example VIII—Preparation of lithographic printing plate
A photosensitive coating mixture is prepared having the following composition:

| | Component | g |
|---|---|---|
| (a) | Terpolymer of 17% ethyl acrylate, 71% methyl methacrylate, and 12% acrylic acid; mol. wt. ca. 300,000; acid number ca. 105 | 5 |
| (b) | Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 51 |
| (c) | Polyoxyethylated trimethylolpropane triacrylate (20 moles of ethylene oxide) (M.W. 1162) | 12 |
| (d) | Trimethylolpropane triacrylate | 12 |
| (e) | Benzophenone | 3 |
| (f) | Michler's ketone | 0.25 |
| (g) | Polyethylene beads of Example I | 13 |
| (h) | 2,2'-Bis(2-chlorophenyl)-4,4',5,5'-tetraphenyl biimidazole | 3 |
| (i) | Leuco crystal violet | 0.4 |
| (j) | Benzotriazole | 0.2 |
| (k) | 1,4,4-Trimethyl-2,3-diazobicyclo-[3.2.2]-non-2-ene-2,3-dioxide | 0.06 |
| (l) | Victoria Green (C.I. Pigment Green 18) | 0.03 |
| (m) | Methylene chloride | 215 |
| (n) | Methanol | 25 |

The mixture is coated on a 0.00127 cm thick polyethylene terephthalate web and dried to give a photopolymerizable layer with a dry thickness of 0.00254 cm. The layer had an elongation at break of about 45% and optical density below 0.7.

The photosensitive layer is laminated to the clean anodized surface of a thin aluminum plate and self trimmed using the lamination procedure of Example II wherein the thin layer of liquid consists of 30% ethanol in water.

The laminated and trimmed board is imaged by exposing for sixty seconds the photosensitive layer through a halftone transparency to UV radiation from a Colight® DMVL-HP light source. The unexposed areas are completely removed by development as in an aqueous solution of sodium carbonate to provide a halftone polymeric image with complimentary image areas of bare aluminum surface. The resulting lithographic printing plate is conventionally gummed, inked and used to produce numerous printed copies.

Example IX—Preparation of a lithographic printing plate
A photosensitive coating mixture was prepared and coated as in Example I except that instead of the beads used therein, 16 g of 1 μm polyethylene beads (Microfine VIII—F. Gold, tradename of Dura Commodities Corporation, Harrison, NY) were dispersed in the coating solution. The surface of a 0.023 cm thick aluminum plate was scrubbed with tungsten carbide brushes in water using a Chemcut Model 107 (tradename of Chemcut Corporation, State College, PA) Mechanical Cleaning System and the scrubbed surface was laminated to the photosensitive layer and the layer trimmed as described in Example I.

The laminated and trimmed board was imaged by exposing for 60 s the photosensitive layer through a halftone and line transparency to U.V. radiation from a 2000 watt pulsed Xenon arc light source in a flip top

14

platemaker. The unexposed areas were completely removed by development in a 1% aqueous solution of sodium carbonate to provide a halftone polymeric image with complimentary image areas of bare aluminum surface. The resulting lithographic printing plate was conventionally gummed with Lydex Finishing Solution (LDFS) (tradename of E.I. du Pont de Nemours and Company, Wilmington, DE) and mounted on a A.B. Dick Model 380 offset printing press. Using standard inking and fountain solutions, at least 3500 copies of good quality were obtained from the printing plate.

In the foregoing photosensitive elements, the photosensitive layers, if formulated without a solid discontinuous phase, would have an elongation-at-break of greater than 150%.

**Claims**

1. Photoresist element comprising a photosensitive layer coated upon a strippable support, the photosensitve layer when laminated to a substrate being self-trimmable on the edges of the substrate by the application of tensile stress to the layer transversely to the edge, when the strippable support is removed, comprising (a) an addition polymerizable ethylenically unsaturated monomer, (b) an initiating system activatable by actinic radiation and (c) a binder comprising a continuous major phase of organic polymer compatible with (a) and (b) and a discontinuous minor phase of randomly dispersed nonfibrous solid particles having a particle size of from 0.1 to 25 µm, the optical density (Enzyklopädie Naturwissenschaft und Technik, vol. 3, 1980, page 3103, "Optische Dicke τ") of the layer being below 0.7 and the photopolymerizable composition being present in dry coating thickness of 0.0008 to 0.025 cm, characterized in that said solid particles are polyolefine or poly-(tetrafluoroethylene), the photosensitive layer has an elongation at break between 2 and 50%, and the photosensitive layer without the solid particles has an elongation at break of greater than 150%.

2. The photoresist element of claim 1 in which the photosensitive layer has an elongation at break between 5 and 30%.

3. The photoresist element of claim 2 in which the solid particles are polyethylene or polypropylene beads.

4. The photoresist element of claim 1 to 3 having a removable protective cover sheet.

5. Method of trimming a polymeric material evenly along the edge of a substrate having the polymeric layer laminated thereto by applying a tensile stress transversely to the edge of the laminated layer in excess of the tensile breaking strength of the layer, characterized in that a discontinuous minor phase of randomly dispersed nonfibrous solid particles having a particle size of from 0.1 to 25 µm is incorporated into the polymeric layer which has an elongation at break of greater than 150% without the solid particles and an elongation at break between 2 and 50% with the solid particles.

**Patentansprüche**

1. Photoresist-Element mit einer auf einen abstreifbaren Träger aufgetragenen lichtempfindlichen Schicht, die, wenn sie auf ein Substrat laminiert ist, sich an den Kanten des Substrats selbsttätig durch Einwirkung einer Zugspannung auf die Schicht quer zu der Kante glattzustutzen vermag, wenn der abstreifbare Träger entfernt wird, umfassend (a) ein additionspolymerisierbares, ethylenisch ungesättigtes Monomer, (b) ein durch aktinische Strahlung aktivierbares initiierendes System und (c) ein Bindemittel aus einer geschlossenen, in größerer Menge vorliegenden Phase eines mit (a) und (b) verträglichen Polymers und einer unterbrochenen, in kleinerer Menge vorliegenden Phase statistisch verteilter, nicht-faserförmiger fester Teilchen mit einer Teilchengröße von 0,1 bis 25 µm, wobei die optische Dichte (Enzyklopädie Naturwissenschaft und Technik, Band 3, 1980, Seite 3103, "Optische Dicke τ") der Schicht unterhalb von 0,7 liegt und die photopolymerisierbare Zusammensetzung in einer Dicke der trockenen Beschichtung von 0,0008 bis 0,025 cm vorliegt, dadurch gekennzeichnet, daß die festen Teilchen Polyolefin oder Poly(tetrafluoroethylen) sind, die lichtempfindliche Schicht eine Reißdehnung zwischen 2 und 50% aufweist und die lichtempfindliche Schicht ohne die festen Teilchen eine Reißdehnung von mehr als 150% aufweist.

2. Photoresist-Element nach Anspruch 1, dadurch gekennzeichnet, daß die lichtempfindliche Schicht eine Reißdehnung zwischen 5 und 30% aufweist.

3. Photoresist-Element nach Anspruch 2, dadurch gekennzeichnet, daß die festen Teilchen Polyethylen- oder Polypropylen-Perlen sind.

4. Photoresist-Element nach Ansprüchen 1 bis 3 mit einer entfernbaren Schutzdeckfolie.

5. Verfahren zum gleichmäßigen Glattstutzen eines polymeren Materials entlang der Kante eines Substrats, auf das die polymere Schicht auflaminiert ist, durch Einwirkung einer die Reißfestigkeit der Schicht übersteigenden Zugspannung auf dasselbe quer zu der Kante der laminierten Schicht, dadurch gekennzeichnet, daß eine unterbrochene Phase statistisch verteilter, nichtfaserförmiger fester Teilchen mit einer Teilchengröße von 0,1 bis 25 µm in die polymere Schicht eingearbeitet wird, die ohne die festen Teilchen eine Reißdehnung von mehr als 150% und mit den festen Teilchen eine Reißdehnung zwischen 2 und 50% aufweist.

15

# 0 041 643

Revendications

1. Elément de réserve photosensible comprenant une couche photosensible appliquée sur un support arrachable, la couche photosensible quand elle est stratifiée à un substrat étant auto-rognable le long des bords du substrat par l'application d'une contrainte de traction à la couche transversalement par rapport au bord, quand le support arrachable est enlevé, comprenant (a) un monomère éthylèniquement insaturé polymérisable par addition, (b) un système initiateur activable par radiation actinique et (c) un liant comprenant une phase majeure continue de polymère organique compatible avec (a) et (b) et une phase mineure discontinue de particules solides non-fibreuses dispersées au hasard ayant une grosseur de particules de 0,1 à 25 µm, la densité optique (Enzyklopädie Naturwissenschaft und Technik, Vol. 3, 1980, page 3103, "Optische Dicke τ") de la couche étant inférieure à 0,7 et la composition photopolymérisable étant présente à une épaisseur de revêtement sec de 0,0008 à 0,025 cm, caractérisé en ce que lesdites particules solides sont des particules de polyoléfine ou de poly-(tétrafluoroéthylène), la couche photosensible a un allongement à la rupture compris entre 2 et 50%, et la couche photosensible sans les particules solides a un allongement à la rupture de plus de 150%.

2. Elément de réserve photosensible selon la revendication 1, dans lequel la couche photosensible a un allongement à la rupture compris entre 5 et 30%.

3. Elément de réserve photosensible selon la revendication 2, dans lequel les particules solides sont des perles de polyéthylène ou de polypropylène.

4. Elément de réserve photosensible selon l'une des revendications 1 à 3 ayant une feuille de revêtement protectrice enlevable.

5. Procédé pour rogner une matière polymère de façon égale le long du bord d'un substrat ayant la couche polymère stratifiée à lui, par application d'une contrainte de traction, transversalement par rapport au bord de la couche stratifiée, supérieure à la contrainte de rupture par traction de la couche, caractérisé en ce qu'une phase mineure discontinue de particules solides non-fibreuses dispersées au hasard ayant une grosseur de particules de 0,1 à 25 µm est incorporée dans la couche polymère qui a un allongement à la rupture de plus de 150% dans les particules solides et un allongement à la rupture compris entre 2 et 50% avec les particules solides.